(19) Europäisches Patentamt

European Patent Office

Office européen des brevets

(11) **EP 0 507 139 B1**

(12) **EUROPÄISCHE PATENTSCHRIFT**

(45) Veröffentlichungstag und Bekanntmachung des Hinweises auf die Patenterteilung:
**05.03.1997 Patentblatt 1997/10**

(51) Int Cl.6: **H04B 1/12**

(21) Anmeldenummer: **92104467.3**

(22) Anmeldetag: **16.03.1992**

(54) **Verfahren zur Nachbarkanalunterdrückung beim Empfang frequenzmodulierter Sender**

Method for adjacent channel rejection at reception of FM-modulated signals

Procédé de suppression des signaux des canaux adjacents en réception FM

(84) Benannte Vertragsstaaten:
**DE FR IT PT**

(30) Priorität: **27.03.1991 DE 4110084**

(43) Veröffentlichungstag der Anmeldung:
**07.10.1992 Patentblatt 1992/41**

(73) Patentinhaber: **Blaupunkt-Werke GmbH
D-31132 Hildesheim (DE)**

(72) Erfinder:
- **Rüngeler, Andreas, Dr.
  W-7141 Benningen (DE)**
- **Raichle, Franz
  W-7016 Gerlingen (DE)**

(56) Entgegenhaltungen:
**EP-A- 0 184 018**

- **"A cross coupled PLL interference canceller with closed loop amplitude control". Bar-ness et al. IEEE Global Telecommunications Conference.**

**Beschreibung**

Die Erfindung betrifft ein Verfahren zur Nachbarkanalunterdrückung beim Empfang frequenzmodulierter Signale nach dem Oberbegriff des Anspruchs 1.

Das Frequenzspektrum frequenzmodulierter Sender ist an sich unendlich breit. In der Praxis lassen sich jedoch Stereosignale, deren Kanäle das hörbare Frequenzspektrum von 30 bis 15000 Hz enthalten, mit hinreichend geringen Verzerrungen wiedergeben, wenn empfangsseitig die Bandbreite des frequenzmodulierten Signals durch ZF-Filterung auf ca. 300 kHz beschränkt wird.

Um hierbei die einzelnen Sender einwandfrei selektieren zu können, müßten die Sender in einem Kanalraster von mindestens 300 kHz arbeiten. Tatsächlich beträgt das Kanalraster aber nur 100 kHz. Dieser Umstand wäre dann nicht störend, wenn die Sendefrequenzen in Verbindung mit den Senderstandorten so koordiniert wären, daß aufgrund der begrenzten Reichweiten von UKW-Sendern sichergestellt wäre, daß an jedem möglichen geografischen Standort nur solche Sender einfallen, die einen gegenseitigen Frequenzabstand von mindestens 300 kHz aufweisen.

Durch den Ausbau des Sendernetzes werden die Bedingungen für einen ungestörten Empfang jedoch nicht mehr an jedem geografischen Standort eingehalten. So kommt es vor, daß zusätzlich zu dem Nutzsignal des Senders, auf den der Empfänger abgestimmt wurde, ein Störsignal eines auf dem Nachbarkanal arbeitenden Senders empfangen wird. Das Signalgemisch aus Nutzsignal und Störsignal läßt sich durch analoge ZF-Filterung nicht trennen.

Es wurde bereits vorgeschlagen, zur Demodulation von frequenzmodulierten Signalen mit überlappenden Spektren komplexe digitale Basisbandsignale zu gewinnen und diese Signale mit Hilfe zweier Demodulatoren, die jeweils auf einen der Träger der frequenzmodulierten Signale abgestimmt sind, zu demodulieren. Dabei lassen sich Schätzsignale für die Phase und die Amplitude des einen und des anderen Signals gewinnen. Aus der Veröffentlichung "Cross coupled PLL interference canceller with closed loop amplitude control", Bar-Ness et al, IEEE Global Telecommunications Conference, 29 Nov - 2 Dec 1982, Seite 691-695) ist bekannt, durch gegenseitige Kopplung der Demodulatoren in einer Kreuzstruktur nach Remodulation der Schätzsignale diese von den komplexen digitalen Basisbandsignalen gegenseitig abzuziehen. Dadurch lassen sich im eingeschwungenen Zustand die den überlappenden Spektren entsprechenden Signale trennen.

Durch auf dem Signalweg eintretende Verzerrungen wird die Momentanamplitude des Nutzsignals und des Störsignals beeinflußt. Es handelt sich hier um Störkomponenten, die auf dem Einfluß des ZF-Filters beruhen und solche, die durch Änderungen des Empfangspegels an der Antenne aufgrund von Dämpfungen des Übertragungsweges hervorgerufen werden. Die Dimensionierung einer Amplitudenregelung, die beide Störkomponenten berücksichtigen soll, würde einen Kompromiß darstellen, der eine befriedigende Kompensation der Amplitudenschwankungen nicht in jedem Fall gewährleistet.

Aus der EP 0 184 018 A 2 ist ein Demodulator für einen digitalen Empfänger bekannt, bei dem vor dem Analog-DigitalWandler ein schmalbandiges Filter vorgeschaltet ist. Die dabei auftretenden Phasen- und Dämpfungsverzerrungen werden mittels eines Entzerrernetzwerkes kompensiert. Dieses Netzwerk ist auch so ausgestaltbar, daß es zur Entzerrung bei Mehrwegempfang dienen kann.

Der Erfindung liegt die Aufgabe zugrunde, ein Verfahren zur Nachbarkanalunterdrückung beim Empfang frequenzmodulierter Signale dahingehend zu verbessern, daß die Einflüsse durch das ZF-Filter und durch Dämpfungen des Übertragungsweges auf die Momentanamplitude wirksam kompensiert werden können.

Diese Aufgabe wird bei einem Verfahren nach dem Oberbegriff des Anspruchs 1 durch die im kennzeichnenden Teil angegebenen Merkmale gelöst.

Die Erfindung geht davon aus, daß die Amplitudenschwankungen beim Stör- und beim Nutzsignal, hervorgerufen einerseits durch den Amplitudengang des ZF-Filters und andererseits durch Dämpfungen des Übertragungsweges mit unterschiedlichen Frequenzen auftreten. Während der Empfangspegel an der Antenne im Vergleich zur Modulationsfrequenz $f1$ relativ langsam schwankt, bewirkt das ZF-Filter beim Nutzsignal eine Amplitudenmodulation mit $2f1$ und beim Störsignal eine mit $f1$. Ein Regelkreis für die komplexe Amplitudenregelung müßte für eine optimale Kompensation des Amplitudenganges des ZF-Filters möglichst breitbandig ausgelegt sein, während er für eine optimale Kompensation der Dämpfungen des Übertragungsweges möglichst schmalbandig bemessen werden müßte.

Diese beiden gegenläufigen Forderungen lassen sich bei der Bemessung eines einzigen Regelkreises nicht erfüllen. Die Erfindung sieht deshalb vor, die Einflüsse auf die Momentanamplitude entsprechend den obigen Ursachen getrennt zu kompensieren.

Da der Frequenzgang der Amplitude des ZF-Filters alle Frequenzen des FM-Spektrums beeinflußt und dieser Zusammenhang nicht einfach angegeben werden kann, wird ein quasistatisches Modell benutzt, das unter bestimmten Bedingungen eine einfache Näherung zur Bestimmung des Einflusses des ZF-Filters ermöglicht. Dieses quasistatische Modell nimmt an, daß aufgrund kleiner Werte für die Modulationsfrequenz und den Frequenzhub die Frequenzänderung der FM-Schwingung so langsam erfolgt, daß sich das System in jedem Augenblick im eingeschwungenen Zustand befindet. In diesem Fall muß zur Berechnung des Einflusses des ZF-Filters auf die Momentanamplitude nicht das gesamte Frequenzband betrachtet werden, sondern es genügt, lediglich den Wert des Betragsfrequenzganges des ZF-Filters bei der im Augenblick demodulierten Momentanfrequenz zu bestimmen.

Nachfolgend wird die Erfindung anhand der Zeichnung erläutert. Diese zeigt in

Fig. 1    ein Blockschaltbild des ZF- und Demodulator-Teils eines FM-Empfängers mit kreuzgekoppelten digitalen PLL-Schaltkreisen und in

Fig. 2    ein Blockschaltbild eines digitalen PLL-Schaltkreises mit einer Schaltung zur Amplitudennachbildung.

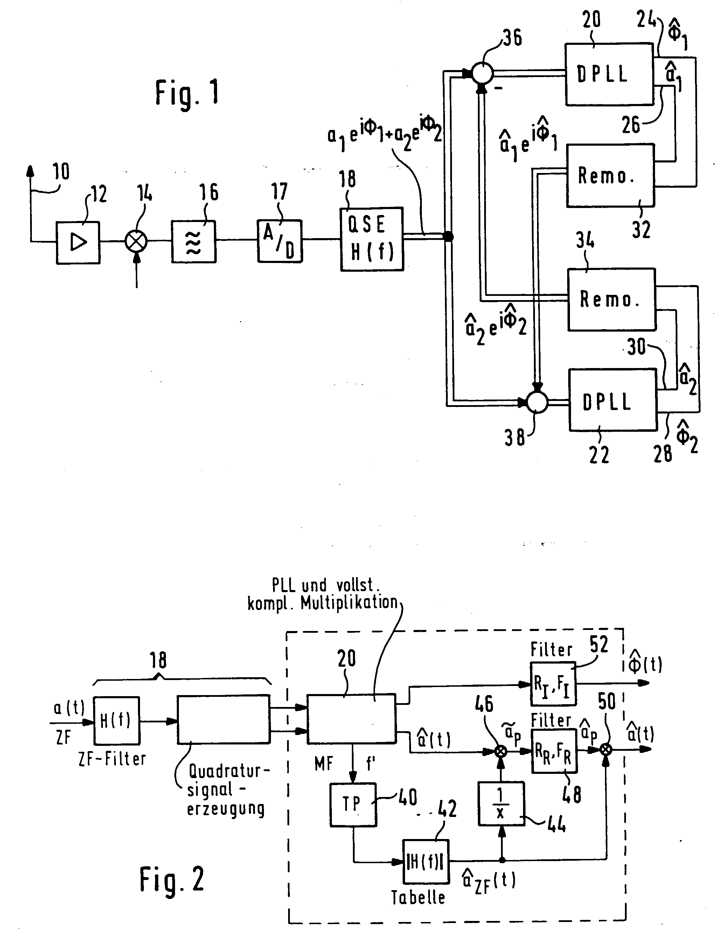

Bei der Schaltung gemäß Fig. 1 gelangen Signale von einer Antenne 1Ø über einen Vorverstärker 12 und eine Mischstufe 14 zu einem analogen ZF-Filter 16. Am Ausgang des analogen ZF-Filters steht ein frequenzmoduliertes ZF-Signal der Mittenfrequenz 1Ø,7 MHz. Dieses ZF-Signal wird in einem nachfolgenden Analog-Digitalwandler 17 mit der Abtastfrequenz fA abgetastet und in ein digitales Signal umgewandelt. In einem weiteren Schaltkreis 18 zur Quadratursignalerzeugung und digitalen ZF-Filterung wird das digitale Signal durch Abtastreduktion ins komplexe Basisband abgemischt und gleichzeitig einer digitalen Filterung unterzogen. Die Bandbreite beträgt nun ca. 3ØØ kHz. Durch die digitale Filterung läßt sich ein linearer Phasengang erzielen.

Am Ausgang des Schaltkreises 18 liegt dementsprechend das digitale komplexe Basisbandsignal in der Form $a1\, e^{i\Phi 1} + a2\, e^{i\Phi 2}$ vor, wobei a1 die Amplitude des Nutzsignals, a2 die Amplitude des Störsignals, $\Phi$1 die Phase des Nutzsignals und $\Phi$2 die Phase des Störsignals darstellen.

Von den beiden nachgeschalteten digitalen PLL-Schaltkreisen 2Ø, 22 ist der Schaltkreis 2Ø auf den Träger des Nutzsignals und der Schaltkreis 22 auf den Träger des Störsignals, nämlich des Nachbarkanals abgestimmt. Durch Demodulation der Basisbandsignale ergeben sich an dem einen Ausgang 24 des Schaltkreises 2Ø Schätzwerte für die Phase $\Phi$1 des Nutzsignals und an dem anderen Ausgang 26 des Schaltkreises 2Ø Schätzwerte für die momentane Amplitude a1 des Nutzsignals. Demgegenüber sind an einem Ausgang 28 des Schaltkreises 22 Schätzwerte für die Phase $\Phi$2 des Störsignals und an dem anderen Ausgang 3Ø des Schaltkreises 22 Schätzwerte für die momentane Amplitude a2 des Störsignals abgreifbar.

Auf der Basis dieser Schätzwerten werden durch Remodulation in Schaltkreisen 32 und 34 Anteile des Störsignals und des Nutzsignals gewonnen, die von dem komplexen Basisbandsignal in Verknüfungsstufen 36 und 38 abgezogen werden können. Im eingeschwungenen Zustand sind dann die Eingangssignale am Schaltkreis 2Ø so weit von Störsignalen befreit, daß auch die Schätzwerte an den Ausgängen den realen Werten sehr genau angeglichen sind und entsprechendes gilt für die Eingangssignale am Schaltkreis 22 und die Schätzwerte an dessen Ausgängen.

Um eine dynamische Schätzung der Amplitudenverhältnisse aufgrund des Amplitudenganges des ZF-Filters und der Dämpfungen des Übertragungsweges zu erzielen und damit auch die Voraussetzungen für eine Demodulation in einer hier nicht erläuterten Geradeausstruktur statt der in Fig. 1 dargestellten kreuzgekoppelten Struktur der Demodulatoren zu erzielen, wird nun die in Fig. 2 dargestellte Schaltung zur Amplitudennachbildung beschrieben. Bei dieser Ausgestaltung ist der Schaltkreis 2Ø in Fig. 1 durch die in der Umrahmung der Fig. 2 dargestellten Schaltkreise ergänzt.

Hierbei wird das von dem digitalen PLL-Schaltkreis detektierte Signal f', die Momentanfrequenz durch einen einfachen Tiefpaß 4Ø gefiltert und zur Adressierung der in einer Tabelle eines adressierbaren Speichers 42 abgelegten ZF-Charakteristik herangezogen. Daraus ergibt sich ein Schätzsignal $\hat{a}_{ZF}(t)$ für die bei der entsprechenden Momentanfrequenz f' durch das ZF-Filter verursachte Bewertung des empfangenen Nutz- bzw. Störsignals. Die durch die vollständige komplexe Multiplikation gewonnene Größe $\tilde{a}(t)$ wird mit dem im Schaltkreis 44 gebildeten Kehrwert des Schätzsignals, also dem Wert $1/\hat{a}_{ZF}(t)$ an der Verknüpfungsstelle 46 gewichtet, wonach die durch unvollständige Kompensation gestörte Größe $\tilde{a}_P(t)$ verbleibt. Diese Größe stellt in etwa die Amplitudenschwankung aufgrund der Dämpfung im Übertragungsweg dar.

Da sich die Größe $a_P(t)$ im Vergleich zur NF-Frequenz f1 nur langsam ändert, kann das nachfolgende Filter 48 schmalbandig ausgelegt sein. Das am Ausgang des Filters 48 weitgehend störbefreite Signal $\hat{a}_P(t)$ wird nun mit dem Signal $\hat{a}_{ZF}(t)$ an der Verknüpfungsstelle 5Ø bewertet und das Ergebnis dieser Bewertung liefert den Schätzwert der Momentanamplitude $\hat{a}(t)$.

Das am anderen Ausgang der digitalen PLL anliegende Signal für die Phase ist weniger starken Störeinflüssen als die Amplitude unterworfen, so daß zur Gewinnung eines Schätzsignals für die Phase aus dem demodulierten Eingangssignal ein einfaches Filter 52 ausreicht.

## Patentansprüche

1.    Verfahren zur Nachbarkanalunterdrückung beim Empfang frequenzmodulierter Signale, bei dem ein Signalgemisch aus einem Nutzsignal und einem aus einem Nachbarkanal stammenden Störsignal nach analoger ZF-Filterung (16), Analog-Digital-Wandlung (17) und Quadratursignalbildung (18) in ein komplexes Basisbandsignal der Form $a1\, e^{i\Phi 1} + a2\, e^{i\Phi 2}$ überführt wird, wobei a1 die Amplitude des Nutzsignals, a2 die Amplitude des Störsignals, $\Phi$1 die Phase des Nutzsignals und $\Phi$2 die Phase des Störsignals darstellen, und durch Demodulation des Störsignals unter Berücksichtigung von auf dem Signalweg eintretenden Verzerrungen Schätzwerte für die Momentanamplitude ($\hat{a}_2$) und Momentanphase ($\hat{\Phi}_2$) des Störsignals $a_2 . e^{i\Phi 2}$ ermittelt wer-

den, die nach Remodulation vom komplexen Basisbandsignal abgezogen werden, <u>dadurch gekennzeichnet</u>, daß die auf dem Signalweg eintretenden Verzerrungen der empfangenen frequenzmodulierten Signale dadurch bestimmt werden, daß die auf dem Übertragungsweg eintretende Dämpfung und die durch den Einfluß des ZF-Filters (16) eintretende Dämpfung getrennt geschätzt werden und daß davon abhängig die Momentanamplitude des Signals korrigiert wird.

2. Verfahren nach Anspruch 1, <u>dadurch gekennzeichnet,</u> daß zur Schätzung des Einflusses des ZF-Filters ein zum momentanen Frequenzwert (f') des demodulierten Signals korrespondierender Amplitudenschätzwert ($\hat{a}_{ZF}$ (t)) des ZF-Filters einer Tabelle (IH (f)I) entnommen und als reziproker Wert ($1/\hat{a}_{ZF}$ (t)) mit dem durch die vollständige komplexe Multiplikation erhaltenen Näherungswert ($\tilde{a}(t)$) für die Momentanamplitude bewertet wird und daß zur Schätzung der während der Übertragung eintretenden Dämpfung ein verbleibender Störamplitudenwert ($\tilde{a}_p$ (t)) schmalbandig gefiltert wird und der nach der Filterung ermittelte Amplitudenschätzwert ($\hat{a}_p$(t)) für den Übertragungungsdämpfungseinfluß mit dem Amplitudenschätzwert ($\hat{a}_{ZF}$(t)) des ZF-Filtereinflusses zur Bildung eines beide Einflüsse berücksichtigenden Schätzwertes ($\hat{a}(t)$) multipliziert wird.

## Claims

1. Method for adjacent channel rejection for the reception of frequency-modulated signals in which a signal mixture composed of a wanted signal and an interference signal originating from an adjacent channel is changed, after analogue IF filtering (16), analogue to digital conversion (17) and quadrature signal formation (18) into a complex baseband signal in the form a1 e $^{i\Phi1}$ + a2 e $^{i\Phi2}$, a1 representing the amplitude of the wanted signal, a2 the amplitude of the interference signal, Φ1 the phase of the wanted signal and Φ2 the phase of the interference signal, and estimated values of the instantaneous amplitude ($\hat{a}2$) and instantaneous phase ($\hat{\phi}2$) of the interference signal a2.ei$\phi$2 being determined by demodulation of the interference signal taking account of distortion occurring on the signal path, which estimated values are subtracted after remodulation of the complex baseband signal, characterized in that that distortion of the received frequency-modulated signals which occurs on the signal path being determined in that the attenuation which occurs on the transmission path and the attenuation which occurs as a result of the influence of the IF filter (16) are estimated separately, and in that the instantaneous amplitude of the signal is corrected as a function of this.

2. Method according to Claim 1, characterized in that an estimated amplitude value ($\hat{a}_{ZF}$(t)) corresponding to the instantaneous frequency value (f') of the demodulated signal of the IF filter is taken from a table ($|H(f)|$) in order to estimate the influence of the IF filter, and is assessed as the reciprocal value ($1/\hat{a}_{ZF}$(t)) using the approximate value ($\tilde{a}(t)$) obtained by complete complex multiplication, for the instantaneous amplitude, and in that a remaining interference amplitude value ($\tilde{a}_p$(t)) is narrowband-filtered in order to estimate the attenuation occurring during the transmission, and the estimated amplitude value ($\hat{a}_p$(t)), determined after the filtering, for the transmission attenuation influence is multiplied by the estimated amplitude value ($\hat{a}_{ZF}$(t)) of the IF filter influence in order to form an estimated value ($\hat{a}(t)$) which takes account of both influences.

## Revendications

1. Procédé de suppression des signaux des canaux adjacents en réception FM, selon lequel on transforme un signal mélangé comprenant le signal utile et un signal parasite provenant d'un canal adjacent, après un filtrage FI, analogique (16), une conversion analogique/numérique (17) et une formation d'un signal en quadrature (18) en un signal de bande de base complexe sous la forme

$$a1 \cdot e^{i\Phi1} + a2 \cdot e^{i\Phi2},$$

a1 représentant l'amplitude du signal utile
a2 l'amplitude du signal parasite
Φ1 la phase du signal utile
Φ2 la phase du signal parasite,
et, par démodulation du signal parasite en tenant compte des distorsions produites dans le chemin du signal, on forme des valeurs évaluées de l'amplitude instantanée ($\hat{a}2$) et de la phase instantanée ($\Phi2$) du signal parasite (a2·i$\Phi$2), puis on retranche, après remodulation, du signal de bande de base complexe,

caractérisé en ce qu'
on détermine les distorsions produites sur le chemin des signaux modulés en fréquence reçus, on évalue de manière séparée l'amortissement produit sur le chemin de transmission et l'amortissement produit par l'influence du filtre FI (16) et, à partir de là, on corrige indépendamment l'amplitude instantanée du signal.

2. Procédé selon la revendication 1,
caractérisé en ce que

pour évaluer l'influence du filtre FI, on prend une valeur d'amplitude évaluée ($\hat{a}_{FI}(t)$) du filtre FI dans un tableau (IH(f)I), pour la valeur de la fréquence instantanée (f') du signal démodulé, et on la pondère par la valeur réciproque ($1/\hat{a}_{FI}(t)$) avec la valeur approchée ($\tilde{a}(t)$), obtenue par multiplication complexe complète, pour l'amplitude instantanée, et pour évaluer l'amortissement qui se produit pendant la transmission, on filtre une valeur d'amplitude parasite ($\tilde{a}_p(t)$) résiduelle, par un filtrage en bande étroite, puis on multiplie la valeur évaluée d'amplitude ($\hat{a}_p(t)$) obtenue par filtrage pour l'influence de l'amortissement de la transmission, par la valeur évaluée de l'amplitude ($\hat{a}_{FI}(t)$) de l'influence du filtre FI, pour former l'une des deux valeurs évaluées ($\hat{a}(t)$), en tenant compte des deux influences.

## Fig. 1

$a_1 e^{i\Phi_1} + a_2 e^{i\Phi_2}$

$\hat{a}_1 e^{i\hat{\Phi}_1}$

$\hat{a}_2 e^{i\hat{\Phi}_2}$

QSE
H(f)

DPLL

Remo.

Remo.

DPLL

## Fig. 2

PLL und vollst.
kompl. Multiplikation

Filter
$R_I, F_I$

$\hat{\Phi}(t)$

Filter
$R_R, F_R$

$\frac{1}{x}$

TP

|H(f)|

Tabelle

$\hat{a}_{ZF}(t)$

$\hat{a}(t)$

$\tilde{a}_P$

$\hat{a}_P$

$\hat{a}(t)$

$\frac{a(t)}{ZF}$

H(f)

ZF-Filter

Quadratursignalerzeugung

MF

f'